# FASCICULE DE BREVET EUROPEEN

(11) **EP 0 726 648 B1**
(45) Date de publication et mention de la délivrance du brevet: **24.10.2001**
(21) Numéro de dépôt: 96200158.2
(22) Date de dépôt: 23.01.1996
(51) Int. Cl.: H03F 3/45, H03B 5/12

(54) **Circuit d'accord pour un appareil récepteur notamment un récepteur de télévision**
Abstimmschaltung für Empfangsgerät insbesondere Fernsehempfänger
Tuning circuit for a receiver apparatus particularly a television receiver

(30) Priorité: 08.02.1995 FR 9501448
(43) Date de publication de la demande: 14.08.1996
(73) Titulaire: Koninklijke Philips Electronics N.V., 5621 BA Eindhoven (NL)
(72) Inventeur: Chevalier, Gilles, F-75008 Paris (FR)
(74) Mandataire: Charpail, François

(56) Documents cités:
- EP-A- 0 353 742
- EP-A- 0 509 124
- GB-A- 2 228 154
- US-A- 5 198 781
- IBM TECHNICAL DISCLOSURE BULLETIN, vol. 34, no. 4a, Septembre 1991 NEW YORK US, pages 99-101, XP 000210839 'TRANSCONDUCTANCE OUTPUT DRIVER'

## Description

La présente invention concerne un circuit d'accord pour un appareil récepteur dans lequel un oscillateur local à fréquence contôlée par une tension est constitué d'un amplificateur couplé à un circuit résonant du type à inductance et capacité variable, une borne de sortie de l'amplificateur étant rétrocouplée en réaction positive sur une entrée de l'amplificateur ainsi qu'à une borne du circuit résonant, circuit dans lequel l'amplificateur comporte un premier étage formé d'une paire différentielle de transistors bipolaires dont les émetteurs réunis sont connectés à une source de courant, paire formée d'un premier transistor dont la base est connectée à une borne d'entrée de l'amplificateur et d'un deuxième transistor dont le collecteur est couplé à une résistance de charge dite principale, ayant une extrémité connectée à une borne d'alimentation et l'autre à laquelle est connectée une borne de sortie de l'amplificateur.

L'invention concerne également un circuit intégré destiné à un appareil récepteur qui comporte des éléments du circuit d'accord précité ainsi qu'un récepteur de télévision utilisant un tel circuit d'accord.

Un circuit d'accord du type indiqué précédemment est présent dans pratiquement tous les appareils récepteurs de radio ou de télévision où il est utilisé pour la sélection, au choix de l'utilisateur, de l'un des canaux disponibles. Dans ce circuit d'accord, l'oscillateur local joue un rôle très important pour produire un signal dit à fréquence intermédiaire, par une différence de fréquence entre le signal à recevoir et le signal de cet oscillateur local. En particulier en ce qui concerne les recepteurs de télévision, une difficulté se présente souvent d'obtenir un oscillateur capable de fonctionner dans une plage étendue de fréquences élevées.

Comme on le sait, l'oscillateur local d'un appareil de réception est constitué d'un dispositif amplificateur couplé à un circuit résonant formé le plus souvent d'un association inductance-capacité. Il est préféré actuellement de construire cet amplificateur à partir d'une paire différentielle de transistors au lieu d'utiliser un transistor unique. De meilleures performances sont obtenues en effet, en particulier en ce qui concerne l'absence d'harmoniques paires dans le signal produit par l'oscillateur local, et le fait que l'impédance d'entrée de l'amplificateur reste élevée sur la majeure partie d'une période du signal de sortie, et qu'elle est donc élevée en moyenne.

Un oscillateur activé au moyen d'une paire différentielle de transistors est connu du document EP-A-0 412 435 dans lequel un circuit résonant de type LC est indiqué.

Lorsqu'on cherche à élargir la gamme de fréquences couvertes par un oscillateur à résonateur LC dans lequel l'élément variable est une diode à capacité variable en fonction d'une tension de commande, on observe qu'une limitation importante se produit dans les fréquences les plus basses où l'oscillateur cesse de fonctionner. Ce phénomène est lié à un coefficient de qualité insuffisant du circuit résonant, dû aux pertes élevées dans la diode à capacité variable.

La capacité variable C étant associée en parallèle avec une inductance L, la résistance de perte parallèle équivalente Rp, de cette capacité, peut être évaluée par un calcul simple, à partir de la résistance de perte série Rₛ. On obtient :

Rp = L/(Rₛ.C)

On remarque que la résistance de perte parallèle Rp diminue lorsque Rs et/ou C augmentent, et donc qu'une oscillation devient difficile aux fréquences basses de la gamme recherchée, circonstances pour lesquelles la valeur de la capacité est élevée.

Une première approche pour résoudre cette difficulté peut consister à utiliser plusieurs diodes associées en série-parallèle pour obtenir une capacité variable dont la qualité est améliorée.

Toutefois cette solution n'est guère satisfaisante du fait que les pertes ne sont que faiblement réduites en fonction du nombre de diodes utilisées, solution qui serait coûteuse et encombrante si on devait utiliser un nombre de diodes très élevé.

Une seconde approche fréquemment utilisée, consiste à placer une capacité fixe (pratiquement exempte de pertes) en série avec la capacité variable, capacité fixe connue sous le nom anglo-saxon de "padder". Selon cette solution, les pertes sont effectivement réduites mais en réduisant la largeur de la bande des fréquences couvertes ce qui est contraire au but recherché.

On peut alors penser qu'une solution au problème posé par un circuit d'accord devant fonctionner dans une plage étendue de fréquences, pourrait provenir d'une augmentation du gain de l'amplificateur activant l'oscillateur local de sorte qu'il soit capable de présenter une résistance négative suffisamment faible, en sortie, pour compenser aux fréquences basses, les pertes élevées du circuit résonant.

Aussi l'un des buts de la présente invention est-il de proposer un circuit d'accord dans lequel l'oscillateur local soit muni d'un amplificateur à gain et fréquence de coupure élevés. Un autre but de l'invention est de fournir un oscillateur utilisant un circuit résonant de type LC, avec lequel la plage de variations de la fréquence d'oscillation soit élargie vers les fréquences basses, du fait que l'amplificateur compense plus efficacement les pertes.

En effet, selon l'invention, un circuit d'accord tel que celui défini dans le paragraphe introductif est caractérisé en ce que l'amplificateur comporte encore un deuxième étage comprenant une paire différentielle de transistors formée d'un troisième et d'un quatrième transistor dont les émetteurs réunis sont connectés au collecteur du deuxième transistor, et en ce que la résistance de charge principale étant connectée au collecteur du troisième transistor, la base de ce troisième transistor est connectée à une extrémité d'une résistance de charge dite annexe, qui est couplée au collecteur du premier transistor, alors que la base du quatrième transistor est connectée à une tension de référence.

Ainsi, le courant collecteur du deuxième transistor, qui contient le signal amplifié par le premier étage, alimente la paire différentielle du deuxième étage, dans laquelle le troisième transistor amplifie à nouveau ce signal, par une commande de sa base provenant du premier étage, commande qui présente la phase convenable.

Selon ce premier mode de mise en oeuvre, l'amplificateur délivre un signal asymétrique sur la borne de sortie. Pour fonctionner en mode asymétrique en entrée, la base du deuxième transistor peut être connectée à une source de tension continue fixée. Toutefois, l'amplificateur peut également recevoir un signal différentiel sur ses deux bornes d'entrée.

Selon une variante de ce mode de mise en oeuvre, le trajet principal de courant d'un transistor cascode est disposé entre le collecteur du premier transistor et la résistance de charge annexe. Un tel étage cascode a pour effet d'augmenter la fréquence de coupure de l'amplificateur en diminuant notamment l'influence des capacités parasites.

Il peut être utile de réduire progressivement le gain de l'amplificateur lorsque la fréquence augmente puisque les pertes importantes du circuit résonant ne sont présentes qu'aux fréquences les plus basses. Il peut donc être avantageux de prévoir que la résistance de charge annexe soit connectée à une capacité en parallèle. Ainsi, la tension de base du troisième transistor reçoit un signal qui est affaibli aux fréquences les plus élevées. Dans d'autres cas, les capacités parasites des transistors utilisés réalisent cet affaiblissement sans qu'il soit nécessaire d'ajouter une capacité supplémentaire.

Un autre mode de mise en oeuvre de l'invention concerne un circuit d'accord pour un appareil récepteur dans lequel un oscillateur local comporte un amplificateur qui peut fonctionner de manière symétrique. Selon ce deuxième mode de mise en oeuve, le circuit d'accord présente un oscillateur local à fréquence contrôlée par une tension formé d'un amplificateur couplé à un circuit résonant du type à inductance et capacité variable, une borne de sortie de l'amplificateur étant rétrocouplée en réaction positive sur une entrée de l'amplificateur ainsi qu'à une borne du circuit résonant, circuit dans lequel l'amplificateur comporte un premier étage formé d'au moins une première paire différentielle de transistors bipolaires dont les émetteurs réunis sont alimentés par une première source de courant, paire constituée d'un premier transistor dont la base est connectée à une première borne d'entrée, et d'un deuxième transistor dont la base est connectée à une deuxième borne d'entrée et dont le collecteur est couplé à une première résistance de charge principale, laquelle a une extrémité connectée à une borne d'alimentation et l'autre connectée à une première borne de sortie de l'amplificateur, tandis que symétriquement, le collecteur du premier transistor est couplé à une deuxième résistance de charge principale qui est connectée à une deuxième borne de sortie de l'amplificateur, circuit caractérisé en ce que le premier étage de l'amplificateur comporte en outre une deuxième paire différentielle de transistors dont les émetteurs réunis sont connectés à une deuxième source de courant, deuxième paire constituée d'une part d'un transistor homologue au premier transistor ayant sa base connectée à la base du premier transistor et son collecteur couplé à une première résistance de charge annexe, et formée d'autre part d'un transistor homologue au deuxième transistor ayant sa base connectée à la base du deuxième transistor et son collecteur couplé à une deuxième résistance de charge annexe, en ce que l'amplificateur comporte encore un deuxième étage formé de deux paires différentielles de transistors :
- une paire de transistors dont les émetteurs réunis sont connectés au collecteur du deuxième transistor, paire dans laquelle l'un des transistors a son collecteur connecté à la première résistance de charge principale et sa base connectée à la première résistance de charge annexe, et l'autre transistor a sa base connectée à la deuxième résistance de charge annexe,
- et une autre paire différentielle de transistors agencée symétriquement par rapport à la paire précédente, dont les émetteurs réunis sont connectés au collecteur du premier transistor, autre paire dans laquelle l'un des transistors a son collecteur connecté à la deuxième résistance de charge principale et sa base connectée à la deuxième résistance de charge annexe, et l'autre transistor a sa base connectée à la première résistance de charge annexe.

Par rapport au premier mode de mise en oeuvre de l'invention, le deuxième étage de l'amplificateur comporte maintenant deux paires de transistors au lieu d'une, tandis que le premier étage comporte une paire différentielle de transistors supplémentaire, couplée à la première paire et servant à fournir les courants dans les deux résistances de charge annexes.

Selon une variante avantageuse de ce mode de mise en oeuvre, le circuit se caractérise en ce que dans le deuxième étage de l'amplificateur, ledit autre transistor dont la base est connectée à la première résistance de charge annexe, a son collecteur connecté à la première résistance de charge principale, et symétriquement, ledit autre transistor dont la base est connectée à la deuxième résistance annexe, a son collecteur connecté à la deuxième résistance de charge principale.

Le gain de cet amplificateur est alors porté à son maximum du fait que les courants collecteur des quatre transistors du deuxième étage sont tous couplés sur l'une des deux résistances de charge, en fonction de la phase des signaux produits par ces transistors.

L'invention concerne également un circuit intégré destiné à équiper un appareil récepteur notamment un récepteur de télévision dans lequel le circuit précédemment défini est incorporé au moins partiellement.

D'autres particularités, détails et avantages seront mis en évidence par la description qui va suivre en regard des dessins annexés, le tout donné à titre d'exemples non limitatifs, dans lesquels :
la figure 1 est un schéma fonctionnel indiquant les parties constitutives d'un circuit d'accord pour un récepteur de télévision,
la figure 2 représente le schéma électrique d'un amplificateur faisant partie d'un oscillateur local modifié conformément à l'invention, dans un mode de mise en oeuvre le plus simple,
la figure 3 donne le schéma électrique d'une variante de l'amplificateur de la figure 2,
la figure 4 est un schéma électrique de l'amplificateur faisant partie du circuit selon l'invention selon un deuxième mode de mise en oeuvre, autorisant un fonctionnement symétrique,
la figure 5 présente le schéma d'une variante de l'amplificateur de la figure 4,
la figure 6 est un schéma simplifié d'application de l'amplificateur décrit aux figures 2 et 3, à un oscillateur fonctionnant en mode asymétrique,
la figure 7 donne le schéma d'un oscillateur fonctionnant en mode symétrique, incorporant un amplificateur du type décrit aux figures 4 ou 5, et
la figure 8 présente un schéma fonctionnel indiquant les parties constitutives d'un récepteur de télévision susceptible d'incorporer le circuit selon l'invention.

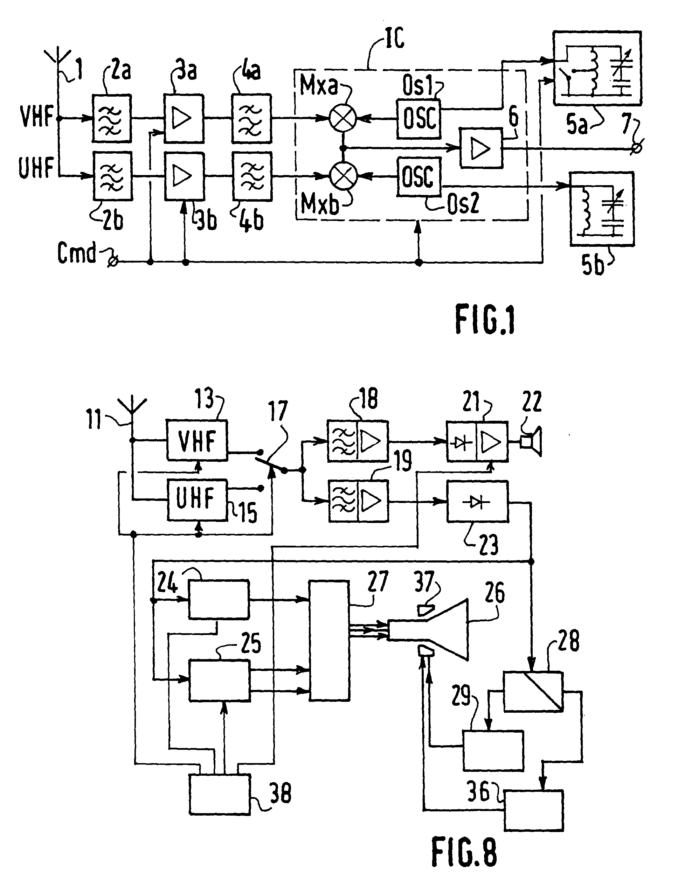

La figure 1 représente de manière très schématique un circuit d'accord pour un récepteur de télévision. Il est généralement divisé en deux sections de composition semblable, une section traitant les signaux de la bande dite VHF et une section traitant ceux de la bande dite UHF. Les signaux reçus sur une antenne 1 sont d'abord traités par des filtres d'entrée respectifs 2a et 2b, puis amplifiés par les préamplificateurs 3a, 3b, et filtrés à nouveau dans des filtres séparateurs de bande 4a et 4b. Les signaux respectifs des bandes VHF et UHF sont ensuite présentés chacun à l'une des entrées de deux mélangeurs Mxa et Mxb.

L'autre entrée desdits mélangeurs reçoit d'une part le signal d'un oscillateur local Os1 en ce qui concerne le mélangeur Mxa et d'autre part, d'un oscillateur local Os2 en ce qui concerne le mélangeur Mxb. Plus précisément, sous les références Os1 et Os2 ont été désignées les parties actives des oscillateurs parties auxquelles sont associées des circuits résonants représentés schématiquement en 5a et 5b qui sont de type inductance et capacité variable. A titre d'exemple, le circuit résonant 5a de l'oscillateur local Os1 correspondant à la bande VHF peut être prévu avec une commutation d'inductance pour fractionner l'intervalle des fréquences en deux sous-bandes.

Les sorties des deux mélangeurs Mxa et Mxb sont réunies et reliées à l'entrée d'un préamplificateur 6 de fréquence intermédiaire dont la sortie 7 constitue également la sortie du circuit d'accord.

Selon un mode de réalisation préféré, les mélangeurs Mxa, Mxb, les parties actives Os1 et Os2 des oscillateurs et le préamplificateur 6 sont regroupés au sein d'un même circuit intégré ce qui est symbolisé sur la figure par le cadre en tirets au repère IC.

Une commande de commutation entre les gammes de fréquence VHF et UHF a été représentée sur la figure 1 par des liaisons provenant d'une borne Cmd. Une telle commande ne nécessite pas de descrition détaillée car elle est bien connue des spécialistes et n'est pas en rapport direct avec les moyens de l'invention.

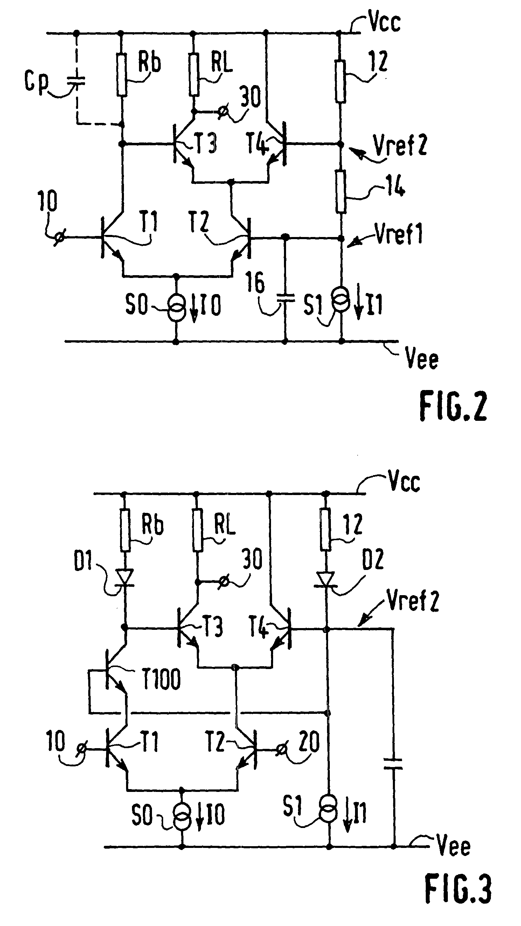

On se réfère maintenant à la figure 2 pour la description d'un amplificateur constituant la partie active de l'un des oscillateurs Os1 ou Os2 de la figure 1, selon un premier mode de réalisation qui, très simplifié, peut être considéré comme un mode de base du principe de l'invention.

L'amplificateur comporte un premier étage formé d'une paire différentielle de transistors bipolaires T1, T2 de type NPN. Les émetteurs réunis de ces transistors sont connectés à une source de courant So, débitant un courant Io. La base du transistor T1 est reliée à une borne d'entrée 10 de l'amplificateur tandis que la base du deuxième transistor T2 est connectée à une source de tension continue Vref1. Cette source est déterminée par la chute de tension procurée par deux résistances 12, 14 en série, parcourues par un courant I1, débité par une source de courant S1, entre une tension d'alimentation Vcc et la masse Vee. La tension continue Vref1 est découplée par rapport à la masse par une capacité 16 qui peut être de faible valeur si l'amplificateur doit fonctionner à très haute fréquence, par exemple 400MHz. Le collecteur du deuxième transistor T2 est connecté aux émetteurs réunis d'une deuxième paire différentielle de transistors formée des transistors NPN T3 et T4, paire différentielle dans laquelle le transistor T3 à son collecteur couplé à la tension d'alimentation Vcc via une résistance de charge RL, appelée par la suite résistance de charge principale. Le quatrième transistor T4 a son collecteur connecté directement à la tension d'alimentation Vcc. Le noeud de connexion entre le collecteur du transistor T3 et la résistance de charge principale RL, est connecté à une borne de sortie 30 de l'amplificateur. Le courant collecteur du deuxième transistor T2, présentant une composante de courant alternatif déjà amplifiée par le premier étage T1-T2, est amplifié à nouveau par la paire différentielle T3-T4 du fait que la base du troisième transistor T3 reçoit un signal de tension ayant la phase convenable, provenant d'une résistance de charge annexe Rb connectée au collecteur du premier transistor T1. L'autre extrémité de cette résistance de charge annexe Rb est connectée à la tension d'alimentation Vcc.

La base du quatrième transistor T4 est connectée à une source de tension de référence Vref2, prélevée entre les résistances 12 et 14.

Un fonctionnement optimal de cet amplificateur est obtenu lorsque la paire de transistors T3, T4 fonctionne de manière équilibrée du point de vue du courant continu c'est-à-dire que, dans l'exemple de la figure 1, si la résistance 12 a une valeur égale à la résistance de charge annexe Rb, le courant I1 débité par la source de courant S1 est alors choisi égal à la moitié du courant Io débité par la source de courant So. Ainsi les bases des transistors T3 et T4 sont-elles polarisées à une tension continue très voisine. Bien entendu, on pourrait obtenir le même résultat par autre choix convenable des valeurs de courant I1 et de la résistance 12.

Comme on le verra par la suite, à propos de l'application de cet amplificateur à un oscillateur large bande, il peut être utile de réduire progressivement le gain de l'amplificateur lorsque la fréquence du signal alternatif augmente. Ceci peut être réalisé de manière très simple en réduisant l'amplification du deuxième étage de transistors T3, T4, par une réduction du signal alternatif de tension appliqué à la base du transistor T3, signal de tension qui est fourni par la résistance de charge annexe Rb. Cette réduction est obtenue par couplage en parallèle sur cette résistance d'une capacité de faible valeur Cp, possibilité qui est représentée sur la figure par une liaison en tirets. Il est donc apparent que l'ensemble formé par la résistance de charge annexe Rb et la capacité parallèle Cp forme une charge complexe permettant de contrôler dans une certaine mesure le gain de cet amplificateur en fonction de la fréquence.

Il s'est avéré en pratique, que les capacités parasites du troisième transistor T3 pouvaient procurer le même effet que la capacité parallèle Cp de sorte que par le choix de la surface du transistor T3 et de son mode de réalisation, il est possible de contrôler la courbe de réponse de l'amplificateur.

Bien entendu, il sera préférable de choisir en tant que quatrième transistor T4, un transistor de la même construction que le transistor T3 de manière à former une paire différentielle équilibrée de transistors.

La figure 3 représente une variante de réalisation de l'amplificateur de la figure 2.

Dans le schéma de la figure 3, les éléments ayant la même fonction sont affectés des mêmes signes de référence. En ce qui concerne le premier étage constitué de la paire de transistor T1, T2, la figure 3 représente le cas d'un amplificateur à entrées différentielles du fait que la base du transistor T2 est reliée à une deuxième borne d'entrée 20, contrairement à l'amplificateur de la figure 2 dans lequel la base du transistor T2 était connectée à une tension de référence.

Une autre différence concernant l'amplificateur de la figure 3 consiste en l'insertion des diodes D1 et D2 qui abaissent d'une tension de jonction en direct la polarisation des bases des transistors T3 et T4. De cette manière, la tension de sortie fournie à la borne de sortie 30 de l'amplificateur peut admettre une excursion de tension plus élevée.

La variante la plus importante du schéma de la figure 3 est constituée par l'interposition d'un transistor cascode T100 entre le collecteur du transistor T1 et la base du transistor T3, ce transistor cascode ayant sa base connectée à une tension fixe par exemple la tension Vref2 déjà utilisée pour polariser la base du transistor T4. La présence du transistor cascode T100 améliore les performances de l'amplificateur du côté des fréquences les plus élevées.

Bien que le montage de la figure 3 soit susceptible d'être alimenté par un signal symétrique du fait de ses deux entrées 10 et 20, l'amplificateur représenté ne possède qu'une seule sortie 30 et est donc asymétrique à ce point de vue.

Il faut remarquer que le choix d'une configuration d'entrée sur le premier étage de l'amplificateur, à savoir : en mode asymétrique, différentiel ou symétrique, est indépendant des autres particularités propres aux circuits représentés aux figures 2 et 3.

On va maintenant décrire des exemples d'amplificateurs à utiliser dans un circuit d'accord selon l'invention qui peuvent fonctionner de manière totalement symétrique et présentant donc deux entrées et deux sorties.

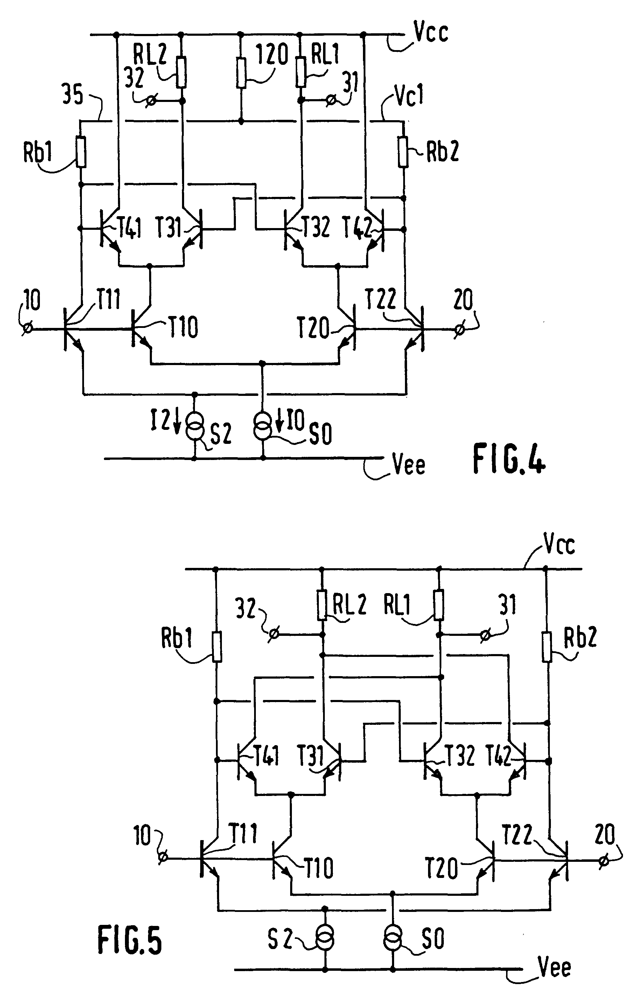

La figure 4 présente le schéma d'un premier exemple d'un tel amplificateur symétrique. Un premier étage comporte une première paire différentielle de transistors T10, T20 dont les bases sont connectées respectivement aux bornes d'entrée 10 et 20. Les émetteurs réunis des transistors T10 et T20 sont alimentés par une source de courant So débitant un courant Io.

L'amplificateur présente, toujours dans le premier étage, une deuxième paire différentielle de transistors T11, T22 dont les bases sont connectées respectivement aux bases des transistors T10 et T20 ainsi qu'aux bornes d'entrée 10 et 20. Les émetteurs réunis de cette deuxième paire différentielle de transistors sont connectés à une deuxième source de courant S2 débitant un courant I2. La paire différentielle des transistors T11 et T22 est utilisée pour fournir des signaux amplifiés de tension aux bases des transistors du deuxième étage. Ceci est réalisé par le couplage du collecteur du transistor T11 à une première résistance de charge annexe Rb1, et le couplage du collecteur du transistor T22 à une deuxième résistance de charge annexe Rb2. Ces deux résistances sont par ailleurs connectées à une ligne 35 de tension d'alimentation Vc1 intermédiaire entre Vcc et Vee. Cette tension Vc1 peut être obtenue simplement à partir de la tension d'alimentation Vcc après chute de tension dans une résistance 120. La chute de tension ainsi créée est apparentée à l'effet des diodes D1 et D2 de l'amplificateur de la figure 3 et procure un effet comparable.

Une autre particularité de ce mode de mise en oeuvre est constituée par le deuxième étage d'amplification qui comporte deux paires différentielles de transistors au lieu d'une seule, à savoir : une paire de transistors T32, T42 dont les émetteurs réunis sont connectés au collecteur du transistor T20, paire qui joue un rôle analogue aux transistors T3 et T4 des exemples précédents. Toutefois, la base du transistor T42 n'est pas connectée à une source de tension de référence mais à une tension variable en fonction de la tension d'entrée du fait qu'elle est connectée à la résistance de charge annexe Rb2. Elle présente donc une tension de base en opposition de phase avec la tension de la base du transistor T32 qui est connectée à la résistance de charge annexe Rb1. Le collecteur du transistor T42 est connecté à la tension Vcc.

La paire de transistors T32, T42 est donc plus active que son équivalent des exemples précédents constitués des transistors T3 et T4 du fait que les bases de cette paire de transistors sont actionnées de manière symétrique. Le collecteur du transistor T32 est couplé à une première résistance de charge principale RL1, résistance qui est connectée par ailleurs à la tension d'alimentation Vcc. Le noeud de connexion entre le collecteur de ce transistor et la résistance RL1 est connecté à une première borne de sortie 31 de l'amplificateur.

Une disposition totalement symétrique est réalisée par une autre paire différentielle de transistors T31, T41 dont les émetteurs réunis sont connectés au collecteur du transistor T10. Le transistor T31, symétrique du transistor T32, a sa base connectée à la résistance de charge annexe Rb2 et son collecteur couplé à une deuxième résistance de charge principale RL2. L'autre extrémité de cette résistance est connectée à la tension d'alimentation Vcc. Le noeud de connexion entre le collecteur du transistor T31 et la résistance RL2 est connecté également à une deuxième borne de sortie 32 de l'amplificateur.

Le transistor T41 qui est symétrique du transistor T42, a sa base connectée à la résistance de charge annexe Rb1 et son collecteur connecté à la tension Vcc. Les bornes d'entrée 10 et 20 de l'amplificateur de la figure 4 peuvent recevoir un signal d'entrée symétrique ou encore un signal asymétrique lorsque l'une des deux bornes est polarisée à une tension de référence fixe. Par contre, du fait de son montage équilibré, les bornes de sortie 31 et 32 portent une tension de sortie qui est symétrique dans tous les cas.

On se reporte à la figure 5 qui présente une variante de réalisation de l'amplificateur décrit à la figure 4.

Dans la mesure du possible, les éléments ayant la même fonction sont affectés des mêmes signes de référence.

Le premier étage de l'amplificateur, composé de la paire différentielle de transistors T10, T20 et de la paire différentielle de transistors T11 et T22, est conforme au premier étage de l'amplificateur de la figure 4. La seule différence réside dans le fait que les résistances de charge annexes Rb1 et Rb2 qui, couplées aux collecteurs des transistors T11 et T22, sont par ailleurs directement reliées à la tension d'alimentation Vcc. Un abaissement de la tension continue moyenne des bases des transistors T41 et T42 peut être obtenu par une augmentation du courant débité par la source de courant S2 ou encore par une augmentation des résistances de charge annexes Rb1 et Rb2. Une différence importante par rapport au schéma de la figure 4, consiste dans le couplage des collecteurs des transistors T41 et T42. Le courant collecteur de ces transistors, qui contient une composante alternative amplifiée est couplé aux résistances de charge RL2, et RL1 de la manière qui convient à la phase de ces signaux. Ainsi, le collecteur du transistor T42 est connecté à la résistance de charge RL2 tandis que le collecteur du transistor T41 est connecté à la résistance de charge RL1. Selon ce mode de réalisation, le maximum de gain est obtenu puisque le deuxième étage ne présente aucune perte de courant alternatif amplifié.

Dans les exemples décrits aux figure 4 et 5, il est clair que les résistances de charges annexes Rb1 et Rb2 peuvent, comme il a été indiqué à propos de la figure 2, être couplées en parallèle à des capacités, de manière à former des impédances de charge qui varient avec la fréquence.

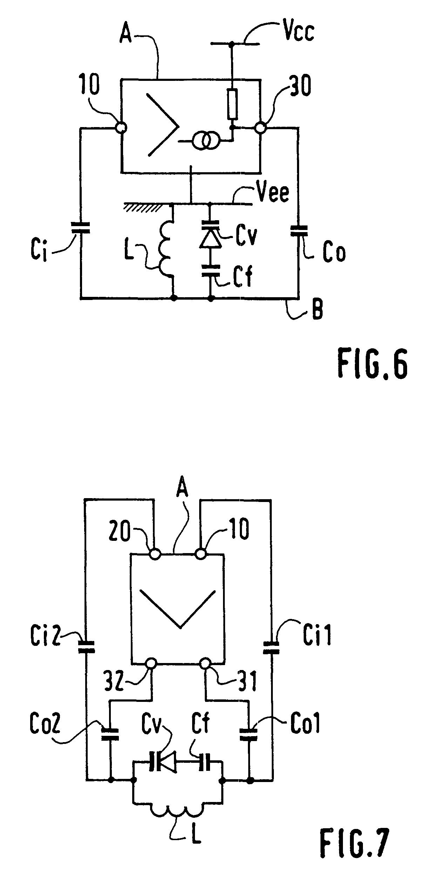

La figure 6 donne un exemple d'utilisation d'un amplificateur de type asymétrique à la réalisation d'un oscillateur à fréquence variable, utilisant un circuit résonant parallèle de type LC.

L'amplificateur A a sa borne de sortie 30 couplée au noeud B du circuit résonant par une capacité de couplage Co. Le circuit résonant est constitué d'une self d'accord L, connectée en parallèle avec une combinaison série de capacités dont l'une est une capacité fixe Cf et l'autre est une capacité variable Cv, susceptible d'être commandée par une tension de commande. Ces éléments self et capacités sont disposés en parallèle entre la masse (Vee) et le noeud B. Le noeud B est encore couplé en réaction positive à la borne d'entrée 10 de l'amplificateur au moyen d'une capacité Ci. Ce rétrocouplage réalise une résistance négative alimentant le circuit oscillant L, Cv + Cf, ce qui engendre l'oscillation du montage. Une extension de la gamme de fréquences couverte par l'oscillateur est obtenue du fait que, aux fréquences les plus basses pour lesquelles la capacité variable Cv présente des pertes importantes, la résistance négative produite par l'amplificateur A est encore suffisamment faible pour permettre à l'oscillateur de fonctionner. Pour permettre cette extension de la gamme de fréquences, la capacité fixe Cf est choisie de valeur assez élevée.

On se reporte à la figure 7 pour un autre exemple d'oscillateur qui utilise maintenant un amplificateur de structure symétrique tel que l'un de ceux présentés en exemples aux figures 4 et 5.

Le circuit résonant de type LC est le même que dans l'exemple précédent mais il est alimenté de manière symétrique. L'amplificateur A a une première sortie 31 couplée au circuit résonant par une capacité de couplage Co1 ainsi qu'à l'entrée 10 de l'amplificateur au moyen d'une capacité de couplage Ci1. De manière symétrique, la deuxième sortie 32 de l'amplificateur est couplée à l'autre extrémité du circuit résonant au moyen d'une capacité de couplage Co2 et est couplée également à la deuxième entrée 20 de l'amplificateur au moyen d'une capacité de couplage Ci2. L'oscillateur de la figure 7, présente les mêmes avantages que l'oscillateur de la figure 6 c'est-à-dire une possibilité d'extension de la gamme des fréquences couvertes. Il bénéficie en outre d'une réjection élevée du mode commun.

La figure 8 présente un schéma synoptique simplifié d'un récepteur de télévision dans lequel le circuit d'accord précédemment décrit peut être incorporé. Les signaux de réception, captés par une antenne 11, sont appliqués à l'entrée d'un sélecteur de canaux composé de deux modules : un module de sélection 13 pour la bande VHF, qui peut être partagée en deux sous-bandes, et un module 15 pour la sélection de la bande UHF. Le signal correspondant à un canal sélectionné par un commutateur 17, dans l'une ou l'autre de ces bandes de fréquences est appliqué en parallèle à l'entrée d'un module 18 effectuant filtrage et préamplification du signal audio ainsi qu'à un module 19 effectuant filtrage et préamplification du signal vidéo. Le signal audio est démodulé puis amplifié en puissance dans un module spécifique 21 dont la sortie est reliée à un haut-parleur 22.

Le signal vidéo préamplifié dans le module 19 est appliqué à l'entrée d'un démodulateur 23 d'où il est ensuite appliqué en entrée à différentes sections du récepteur. Une section composée d'un module 24 de traitement du signal de luminance et d'un module 25 de traitement de la chrominance, fournit des signaux appropriés aux trois canons d'un tube image 26 via un circuit 27 de restitution des trois signaux de couleur et amplification de ces signaux. Une autre section du récepteur est destinée à réaliser la fonction de balayage de l'écran du tube 26 et se compose essentiellement d'un circuit séparateur 28 de synchronisation fournissant des signaux appropriés à un générateur de balayage de ligne 29 et à un générateur de balayage de trame 36 dont les sorties sont connectées à un ensemble de bobines de déviation 37.

Un module de contrôle 38 regroupe des moyens de sélections et de réglages divers qui fournissent des signaux de commande appropriés à la plupart des modules fonctionnels du récepteur ainsi que cela a été représenté schématiquement sur la figure.

Un récepteur de télévision tel que celui qui vient d'être décrit brièvement, est avantageusement équipé d'au moins un circuit d'accord à largeur de bande étendue au moyen de l'invention, circuit pouvant se présenter sous la forme d'un circuit intégré tel que celui décrit en relation avec la figure 1 et matérialisé sur cette figure à la référence IC.

## Revendications

1. Circuit d'accord pour un appareil récepteur dans lequel un oscillateur local à fréquence contôlée par une tension est constitué d'un amplificateur qui est couplé à un circuit résonant du type à inductance et capacité variable, une borne de sortie de l'amplificateur étant rétrocouplée en réaction positive sur une entrée de l'amplificateur ainsi qu'à une borne du circuit résonant, circuit dans lequel l'amplificateur comporte un premier étage formé d'une paire différentielle de transistors bipolaires (T1, T2) dont les émetteurs réunis sont connectés à une source de courant, paire formée d'un premier transistor (T1) dont la base est connectée à une borne d'entrée de l'amplificateur et d'un deuxième transistor (T2) dont le collecteur est couplé à une résistance de charge dite principale (RL), ayant une extrémité connectée à une borne d'alimentation et l'autre à laquelle est connectée une borne de sortie (OUT) de l'amplificateur,
**caractérisé en ce que** l'amplificateur comporte encore un deuxième étage comprenant une paire différentielle de transistors formée d'un troisième (T3) et d'un quatrième transistor (T4) dont les émetteurs réunis sont connectés au collecteur du deuxième transistor (T2),
et **en ce que** la résistance de charge principale (RL) étant connectée au collecteur du troisième transistor (T3), la base de ce troisième transistor est connectée à une extrémité d'une résistance de charge dite annexe (Rb), qui est couplée au collecteur du premier transistor (T1), alors que la base du quatrième transistor est connectée à une tension de référence (Vref2).

2. Circuit d'accord selon la revendication 1, **caractérisé en ce que** la base du deuxième transistor est connectée à une source de tension continue fixée (Vref1).

3. Circuit d'accord selon la revendication 1, **caractérisé en ce que** le trajet principal de courant d'un transistor cascode (T100) est disposé entre le collecteur du premier transistor (T1) et la résistance de charge annexe (Rb).

4. Circuit d'accord selon la revendication 1, **caractérisé en ce que** sur la résistance de charge annexe (Rb) est connectée une capacité en parallèle (Cp).

5. Circuit d'accord pour un appareil récepteur dans lequel un oscillateur local à fréquence contrôlée par une tension est constitué d'un amplificateur qui est couplé à un circuit résonant du type à inductance et capacité variable, une borne de sortie de l'amplificateur étant rétrocouplée en réaction positive sur une entrée de l'amplificateur ainsi qu'à une borne du circuit résonant, circuit dans lequel l'amplificateur comporte un premier étage formé d'au moins une première paire différentielle de transistors bipolaires dont les émetteurs réunis sont alimentés par une première source de courant (So), paire constituée d'un premier transistor (T10) dont la base est connectée à une première borne d'entrée (10), et d'un deuxième transistor (T20) dont la base est connectée à une deuxième borne d'entrée (20) et dont le collecteur est couplé à une première résistance de charge principale (RL1), laquelle a une extrémité connectée à une borne d'alimentation et l'autre connectée à une première borne de sortie (31) de l'amplificateur, tandis que symétriquement, le collecteur du premier transistor est couplé à une deuxième résistance de charge principale (RL2) qui est connectée à une deuxième borne de sortie (32) de l'amplificateur
**caractérisé en ce que** le premier étage de l'amplificateur comporte en outre une deuxième paire différentielle de transistors dont les émetteurs réunis sont connectés à une deuxième source de courant (S2), deuxième paire constituée d'une part d'un transistor (T11) homologue au premier transistor ayant sa base connectée à la base du premier transistor (T10) et son collecteur couplé à une première résistance de charge annexe (Rb1), et formée d'autre part d'un transistor (T22) homologue au deuxième transistor ayant sa base connectée à la base du deuxième transistor (T20) et son collecteur couplé à une deuxième résistance de charge annexe (Rb2),
**en ce que** l'amplificateur comporte encore un deuxième étage formé de deux paires différentielles de transistors :
- une paire de transistors dont les émetteurs réunis sont connectés au collecteur du deuxième transistor (T20), paire dans laquelle l'un (T32) des transistors a son collecteur connecté à la première résistance de charge principale (RL1) et sa base connectée à la première résistance de charge annexe (Rb1), et l'autre transistor (T42) a sa base connectée à la deuxième résistance de charge annexe (Rb2),
- et une autre paire différentielle de transistors agencée symétriquement par rapport à la paire précédente, dont les émetteurs réunis sont connectés au collecteur du premier transistor (T10), autre paire dans laquelle l'un (T31) des transistors a son collecteur connecté à la deuxième résistance de charge principale (RL2) et sa base connectée à la deuxième résistance de charge annexe (Rb2), et l'autre transistor (T41) a sa base connectée à la première résistance de charge annexe (Rb1).

6. Circuit d'accord selon la revendication 5, **caractérisé en ce que** les première (Rb1) et deuxième (Rb2) résistances de charge annexes sont couplées à une borne d'alimentation intermédiaire (Vc1).

7. Circuit d'accord selon la revendication 5, **caractérisé en ce que** dans le deuxième étage de l'amplificateur, ledit autre transistor (T41) dont la base est connectée à la première résistance de charge annexe (Rb1), a son collecteur connecté à la première résistance de charge principale (RL1), et symétriquement, ledit autre transistor dont la base est connectée à la deuxième résistance annexe (Rb2), a son collecteur connecté à la deuxième résistance de charge principale (RL2).

8. Circuit d'accord selon l'une quelconque des revendications 5 à 7, **caractérisé en ce qu'**une capacité (Cp) est connectée en parallèle à chaque résistance de charge annexe .

9. Circuit intégré destiné à équiper un appareil récepteur, **caractérisé en ce qu'**il comporte un amplificateur tel que celui contenu dans le circuit d'accord selon l'une des revendications 1 à 8, ***destiné à former la partie active d'un oscillateur local,*** ainsi qu'un circuit mélangeur (Mxa, Mxb) et un préamplificateur (6) de fréquence intermédiaire.

10. Récepteur de télévision **caractérisé en ce qu'**il inclut un circuit d'accord selon l'une des revendications 1 à 8.

11. Récepteur de télévision **caractérisé en ce qu'**il inclut un circuit intégré selon la revendication 9.

## Patentansprüche

1. Abstimmschaltung für ein Empfangsgerät, in dem ein lokaler, spannungsgesteuerter Oszillator aus einem Verstärker gebildet wird, der an eine Resonanzschaltung induktiven Widerstands und variabler Kapazität gekoppelt ist, wobei eine Ausgangsklemme des Verstärkers an einen Eingang des Verstärkers sowie an eine Klemme der Resonanzschaltung positiv rückgekoppelt ist, der Verstärker in dieser Schaltung eine erste Stufe aufweist, gebildet aus einem Differentialpaar bipolarer Transistoren (T1, T2), deren verbundenen Emitter an eine Stromquelle angeschlossen sind, das Paar aus einem ersten Transistor (T1) gebildet wird, dessen Basis mit einer Eingangsklemme des Verstärkers verbunden ist, und einem zweiten Transistor (T2), dessen Kollektor an einen sogenannten Haupt-Ladewiderstand gekoppelt ist, wobei das eine Ende an eine Versorgungsklemme angeschlossenen und das andere an eine Ausgangsklemme (OUT) des Verstärkers angeschlossen ist,
**dadurch gekennzeichnet, daß** der Haupt-Ladewiderstand (RL) an den Kollektor des dritten Transistors (T3) angeschlossen ist, die Basis dieses dritten Transistors an ein Ende eines sogenannten Neben-Ladewiderstands (Rb) angeschlossen ist, der an den Kollektor des ersten Transistors (T1) gekoppelt ist, während die Basis des vierten Transistors an eine Referenzspannung (Vref2) angeschlossenen ist.

2. Abstimmschaltung nach Anspruch 1, **dadurch gekennzeichnet, daß** die Basis des zweiten Transistors an eine feste Gleichspannungsquelle (Vref1) angeschlossen ist.

3. Abstimmschaltung nach Anspruch 1, **dadurch gekennzeichnet, daß** der Hauptstromweg eines Kaskodentransistors (T100) zwischen dem Kollektor des ersten Transistors (T1) und dem Neben-Ladewiderstand (Rb) angeordnet wird.

4. Abstimmschaltung nach Anspruch 1, **dadurch gekennzeichnet, daß** der Neben-Ladewiderstand (Rb) parallel an eine Kapazität (Cp) angeschlossen ist.

5. Abstimmschaltung für ein Empfangsgerät, in dem ein lokaler Oszillator, dessen Frequenz von einer Spannung gesteuert wird, aus einem Verstärker gebildet wird, gekoppelt an eine Resonanzschaltung induktiven Widerstands und variabler Kapazität, wobei eine Ausgangsklemme des Verstärkers an einen Eingang des Verstärkers sowie an eine Klemme der Resonanzschaltung positiv rückgekoppelt ist, der Verstärker in dieser Schaltung eine erste Stufe aufweist, gebildet aus mindestens einem Differentialpaar bipolarer Transistoren, deren verbundenen Emitter von einer ersten Stromquelle (So) versorgt werden, das Paar aus einem ersten Transistor (T10) gebildet wird, dessen Basis mit einer ersten Eingangsklemme (10) verbunden ist, und einem zweiten Transistor (T20), dessen Basis mit einer zweiten Eingangsklemme (20) verbunden ist und dessen Kollektor an einen ersten Haupt-Ladewiderstand (RL1) gekoppelt ist, wobei das eine Ende an eine Versorgungsklemme angeschlossenen und das andere an eine erste Ausgangsklemme (31) des Verstärkers angeschlossen ist, während der Kollektor des ersten Transistors symmetrisch an einen zweiten Haupt-Ladewiderstand (RL2) gekoppelt ist, der an eine zweite Ausgangsklemme (32) des Verstärkers angeschlossen ist,
**dadurch gekennzeichnet, daß** die erste Verstärkerstufe zudem ein zweites Transistor-Differentialpaar enthalten, deren verbundenen Emitter an eine zweite Stromquelle (S2) angeschlossen sind, wobei das zweite Paar einerseits aus einem zum ersten Transistor homologen Transistor (T11) gebildet wird, dessen Basis an die Basis des ersten Transistors (T10) angeschlossen und dessen Kollektor an einen ersten Neben-Ladewiderstand (Rb1) gekoppelt ist, und andererseits aus einem zum zweiten Transistor homologen Transistor (T22) gebildet wird, dessen Basis an die Basis des zweiten Transistors (T20) angeschlossen und dessen Kollektor an einen zweiten Neben-Ladewiderstand (Rb2) gekoppelt ist,
und **dadurch, daß** der Verstärker zusätzlich eine zweite Stufe aufweist, bestehend aus zwei Transistor-Differentialpaaren:
- ein Transistorpaar, dessen verbundenen Emitter an den Kollektor des zweiten Transistors (T20) angeschlossen sind, wobei der Kollektor einer der Transistoren (T32) des Paars mit dem ersten Haupt-Ladewiderstand (RL1) verbunden ist und seine Basis mit dem ersten Neben-Ladewiderstand (Rb1) verbunden ist, und die Basis des anderen Transistors (T42) mit der Basis des zweiten Neben-Ladewiderstands (Rb2) verbunden ist,
- und ein anderes Transistorpaar, in bezug auf das vorhergehende Paar symmetrisch angeordnet, dessen verbundenen Emitter an den Kollektor des ersten Transistors (T10) angeschlossen sind, wobei der Kollektor einer der Transistoren (T31) des anderen Paars mit dem zweiten Haupt-Ladewiderstand (RL2) verbunden ist und seine Basis mit dem zweiten Neben-Ladewiderstand (Rb2) verbunden ist, und die Basis des anderen Transistors (T41) mit der Basis des ersten Neben-Ladewiderstands (Rb1) verbunden ist.

6. Abstimmschaltung nach Anspruch 5, **dadurch gekennzeichnet, daß** die ersten (Rb1) und zweiten (Rb2) Neben-Ladewiderstände an eine Zwischen-Versorgungsklemme (Vc1) angeschlossen sind.

7. Abstimmschaltung nach Anspruch 5, **dadurch gekennzeichnet, daß** in der zweiten Verstärkerstufe der Kollektor des besagten anderen Transistors (T41), dessen Basis mit dem ersten Neben-Ladewiderstand (Rb1) verbunden ist, mit dem ersten Haupt-Ladewiderstand (RL1) verbunden ist, und symmetrisch der Kollektor des anderen Transistors, dessen Basis mit dem zweiten Neben-Ladewiderstand (Rb2) verbunden ist, mit dem zweiten Haupt-Ladewiderstand (RL2) verbunden ist.

8. Abstimmschaltung nach einem beliebigen der Ansprüche 5 bis 8, **dadurch gekennzeichnet, daß** zu jedem Neben-Ladewiderstand parallel eine Kapazität (Cp) angeschlossen ist.

9. Integrierter Schaltkreis zur Ausrüstung eines Fernsehempfängers, **dadurch gekennzeichnet, daß** er einen Verstärker entsprechend dem in der Abstimmschaltung nach einem der Ansprüche 1 bis 8 enthält, um den aktiven Teil eines lokalen Oszillators zu bilden, sowie eine Mischerschaltung (Mxa, Mxb und einen Zwischenfrequenz-Vorverstärker (6).

10. Fernsehempfänger, **dadurch gekennzeichnet, daß** er eine Abstimmschaltung nach einem der Ansprüche 1 bis 8 enthält.

11. Fernsehempfänger, **dadurch gekennzeichnet, daß** er einen integrierten Schaltkreis nach Anspruch 9 enthält.

## Claims

1. A tuning circuit for a receiver, in which a local oscillator having a voltage-controlled frequency is constituted by an amplifier which is coupled to a resonant circuit of the variable capacitance and inductance type, an output terminal of the amplifier being positively fed back to an input of the amplifier and to a terminal of the resonant circuit, in which circuit the amplifier has a first stage formed by a differential pair of bipolar transistors (T1, T2) whose linked emitters are connected to a current source, which pair is formed by a first transistor (T1) whose base is connected to an input terminal of the amplifier and a second transistor (T2) whose collector is coupled to a main load resistor (RL) having one end connected to a power supply terminal and the other end connected to an output terminal (OUT) of the amplifier,
**characterized in that** the amplifier has also a second stage comprising a differential pair of transistors formed by a third (T3) and a fourth (T4) transistor whose linked emitters are connected to the collector of the second transistor (T2),
and **in that** the main load resistor (RL) is connected to the collector of the third transistor (T3) whose base is connected to one end of a supplementary load resistor (Rb) which is coupled to the collector of the first transistor (T1), while the base of the fourth transistor is connected to a reference voltage (Vref2).

2. A tuning circuit as claimed in claim 1, **characterized in that** the base of the second transistor is connected to a fixed DC source (Vref1).

3. A tuning circuit as claimed in claim 1, **characterized in that** the main current path of a cascode transistor (T100) is arranged between the collector of the first transistor (T1) and the supplementary load resistor (Rb).

4. A tuning circuit as claimed in claim 1, **characterized in that** a capacitor (Cp) is connected parallel to the supplementary load resistor (Rb).

5. A tuning circuit for a receiver, in which a local oscillator having a voltage-controlled frequency is constituted by an amplifier which is coupled to a resonant circuit of the variable capacitance and inductance type, an output terminal of the amplifier being positively fed back to an input of the amplifier and to a terminal of the resonant circuit, in which circuit the amplifier has a first stage formed by at least a first differential pair of bipolar transistors whose linked emitters are fed by a first current source (So), which pair is constituted by a first transistor (T10) whose base is connected to a first input terminal (10) and a second transistor (T20) whose base is connected to a second input terminal (20) and whose collector is coupled to a first main load resistor (RL1) which has one end connected to a power supply terminal and the other end connected to a first output terminal (31) of the amplifier, while symmetrically, the collector of the first transistor is coupled to a second main load resistor (RL2) which is connected to a second output terminal (32) of the amplifier,
**characterized in that** the first stage of the amplifier has also a second differential pair of transistors whose linked emitters are connected to a second current source (S2), said second pair being constituted, on the one hand, by a transistor (T11) which is homologue to the first transistor and has its base connected to the base of the first transistor (T10) and its collector coupled to a first supplementary load resistor (Rb1) and, on the other hand, by a transistor (T22) which is homologue to the second transistor and has its base connected to the base of the second transistor (T20) and its collector coupled to a second supplementary load resistor (Rb2),
and **in that** the amplifier has also a second stage formed by two differential pairs of transistors:
- one pair of transistors whose linked emitters are connected to the collector of the second transistor (T20), in which pair one (T32) of the transistors has its collector connected to the first main load resistor (RL1) and its base connected to the first supplementary load resistor (Rb1), and the other transistor (T42) has its base connected to the second supplementary load resistor (Rb2),
- and another differential pair of transistors controlled symmetrically with respect to the previous pair, whose linked emitters are connected to the collector of the first transistor (T10), in which pair one (T31) of the transistors has its collector connected to the second main load resistor (RL2) and its base connected to the second supplementary load resistor (Rb2), and the other transistor (T41) has its base connected to the first supplementary load resistor (Rb1).

6. A tuning circuit as claimed in claim 5, **characterized in that** the first (Rb1) and second (Rb2) supplementary load resistors are coupled to an intermediate power supply terminal (Vc1).

7. A tuning circuit as claimed in claim 5, **characterized in that** in the second stage of the amplifier said other transistor (T41) whose base is connected to the first supplementary load resistor (Rb1) has its collector connected to the first main load resistor (RL1), and symmetrically, said other transistor whose base is connected to the second supplementary load resistor (Rb2) has its collector connected to the second main load resistor (RL2).

8. A tuning circuit as claimed in any one of claims 5 to 7, **characterized in that** a capacitor (Cp) is connected parallel to each supplementary load resistor.

9. An integrated circuit for a receiver, **characterized in that** it comprises an amplifier as contained in the tuning circuit as claimed in any one of claims 1 to 8, intended to form the active part of a local oscillator, as well as a mixer circuit (Mxa, Mxb) and an intermediate frequency preamplifier (6).

10. A television receiver, **characterized in that** it includes a tuning circuit as claimed in any one of claims 1 to 8.

11. A television receiver, **characterized in that** it includes an integrated circuit as claimed in claim 9.
